(19) Europäisches Patentamt
European Patent Office
Office européen des brevets

(11) **EP 3 322 274 B1**

(12) **EUROPEAN PATENT SPECIFICATION**

(45) Date of publication and mention
of the grant of the patent:
**07.07.2021 Bulletin 2021/27**

(21) Application number: **15897718.1**

(22) Date of filing: **08.07.2015**

(51) Int Cl.:
*H05K 13/04* *(2006.01)*    *H05K 13/08* *(2006.01)*

(86) International application number:
**PCT/JP2015/069624**

(87) International publication number:
**WO 2017/006456 (12.01.2017 Gazette 2017/02)**

(54) **MOUNTING DEVICE**

MONTAGEVORRICHTUNG

DISPOSITIF DE MONTAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**16.05.2018 Bulletin 2018/20**

(73) Proprietor: **FUJI Corporation
Chiryu
Aichi (JP)**

(72) Inventors:
• **KAWAI, Hidetoshi
Chiryu
Aichi (JP)**
• **ITO, Hidetoshi
Chiryu
Aichi (JP)**

(74) Representative: **Grünecker Patent- und
Rechtsanwälte
PartG mbB
Leopoldstraße 4
80802 München (DE)**

(56) References cited:
**JP-A- 2004 281 468    JP-A- 2006 108 331
JP-A- 2006 108 331    JP-A- 2008 021 734
US-A1- 2002 031 279**

• **None**

**Description**

Technical Field

The present invention relates to a mounting apparatus.

Background Art

In the related art, as a mounting apparatus that mounts a component on a board, there is known an apparatus that includes multiple rotatable spindles, suction nozzles that are installed at tips of multiple spindles and suction an electronic component, and a servomotor that rotates the spindle (for example, PTL 1). In PTL 1, a rotation angle of each spindle is adjusted by using an encoder.
PTL 2 to PTL 4 provide further mounting apparatus according to the prior art.

Citation List

Patent Literature

PTL 1: JP-A-2013-143396

PTL 2: US 2002031279 A1

PTL 3: JP 2006108331 A

PTL 4: JP 2004281468 A

Summary of Invention

Technical Problem

However, in the mounting apparatus disclosed in PTL 1, it is possible to detect a rotational position of the spindle by using the encoder; however, positioning accuracy is insufficient for a posture (rotational position) of a held component in some cases. Therefore, there has been a demand for positioning of a posture of a component with higher accuracy.
The present invention is made in consideration of such a problem, and an object thereof is to provide a mounting apparatus that is capable of positioning a posture of a held component with higher accuracy.

Solution to Problem

The present invention adopts the following means for achieving the principal object described above.
A mounting apparatus according to the present invention includes: a mounting head unit able to move in the two horizontal directions a component holding section that is attached to the mounting head unit, is rotatable around a rotation axis and holds a component; a first acquisition section that detects a rotational position of the component holding section and acquires a first rotation value indicating the rotational position; a second acquisition section that detects a specific part of the component holding section and acquires a second rotation value indicating the rotational position of the component holding section; a third acquisition section that detects a rotational position of a component held by the component holding section and acquires a component rotation value indicating the rotational position; a correspondence relationship acquisition section that acquires a correspondence relationship by using the first acquisition section and the second acquisition section; a target rotation value deriving section; and a rotation control section that rotates the component holding section such that the first rotation value acquired by the first acquisition section becomes the target rotation value characterized in that the component holding section is capable of being lifted and lowered, wherein the correspondence relationship acquisition section acquires, as the a correspondence relationship, a correspondence relationship between the first rotation value of the component holding section at a lifted position and the second rotation value of the component holding section at a lowered position, wherein the target rotation value deriving section derives, as the a target rotation value , the first rotation value of the component holding section at the lifted position which corresponds to the second rotation value of the component holding section at the lowered position, by which the component has a target posture at the lowered position of the component holding section, based on the correspondence relationship and a difference between the second rotation value and the component rotation value obtained in a state in which the component holding section holds the component, and wherein the rotation control section rotates the component holding section such that the first rotation value acquired by the first acquisition section at the lifted position of the component holding section becomes the target rotation value .

Advantageous Effects of Invention

In the mounting apparatus, the correspondence relationship between the first rotation value and the second rotation value indicating the rotational position of the component holding section is acquired by using the first acquisition section and the second acquisition section. In addition, the first rotation value corresponding to the second rotation value is derived as the target rotation value, by which the component has the target posture at the lowered position, based on the correspondence relationship and the second rotation value and the component rotation value obtained in the state in which the component holding section holds the component at the lifted position. The component holding section is rotated such that the first rotation value acquired by the first acquisition section becomes the target rotation value. As described above, the correspondence relationship between the first rotation value and the second rotation value is acquired in advance, and the second rotation value and the component rotation value are acquired in a state in which the component holding section holds the component. In this manner, since it is possible to identify correspondence between the first rotation value and the component rotation value in the state of holding the component, it is possible to derive the first rotation value, that is, the value and the component rotation value in the state of holding the component, it is possible to derive the first rotation value, that is, the target rotation value, by which the component has the target posture, with higher accuracy. The component holding section is rotated such that the first rotation value acquired by the first acquisition section becomes the target rotation value, and thereby it is possible to position the posture of the held component with higher accuracy.

Brief Description of Drawings

[Fig. 1] Fig. 1 is a view schematically illustrating a mounting system 10.
[Fig. 2] Fig. 2 is a view schematically illustrating a mounting head unit 17.
[Fig. 3] Fig. 3 is a view illustrating the mounting head unit 17 including a mounting head 50.
[Fig. 4] Fig. 4 is a block diagram illustrating an electrical connection relationship of a mounting apparatus 11.
[Fig. 5] Fig. 5 is a flowchart illustrating an example of a correspondence relationship acquiring process routine.
[Fig. 6] Fig. 6 is a view illustrating a relationship between a first rotation value and a second rotation value.
[Fig. 7] Fig. 7 is a view illustrating an example of correspondence relationship information 86.
[Fig. 8] Fig. 8 is a flowchart illustrating an example of a component picking and disposition process routine.
[Fig. 9] Fig. 9 is a view illustrating an example of acquiring a second rotation value Qu and a component rotation value Pu.

Description of Embodiments

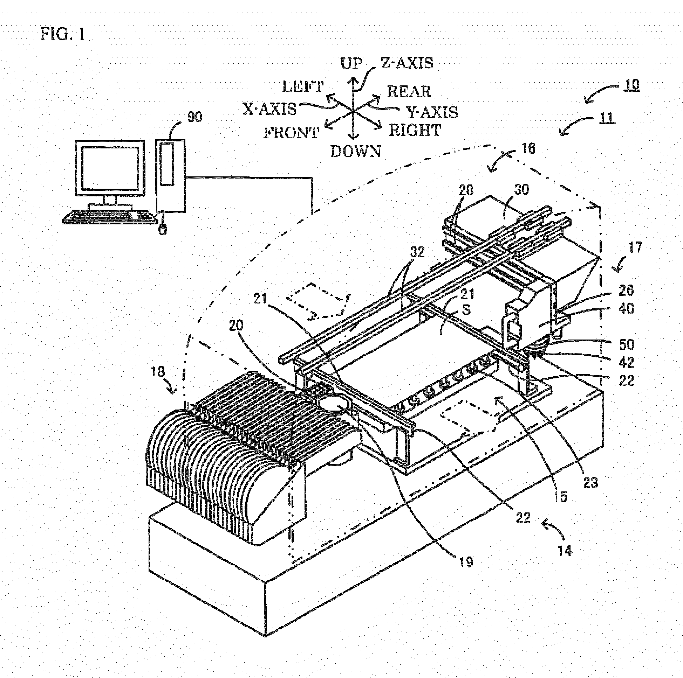

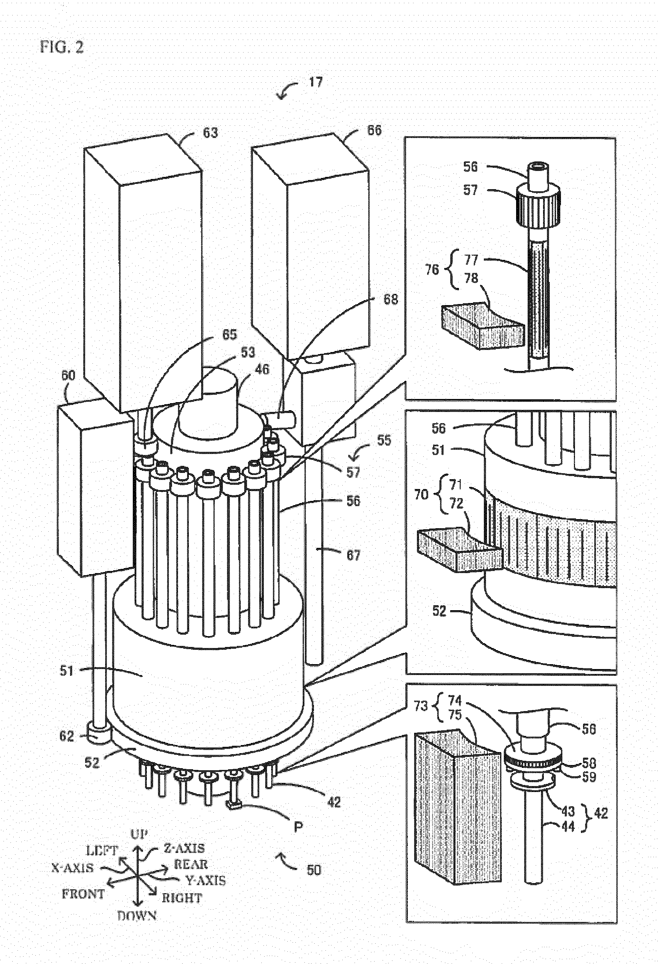

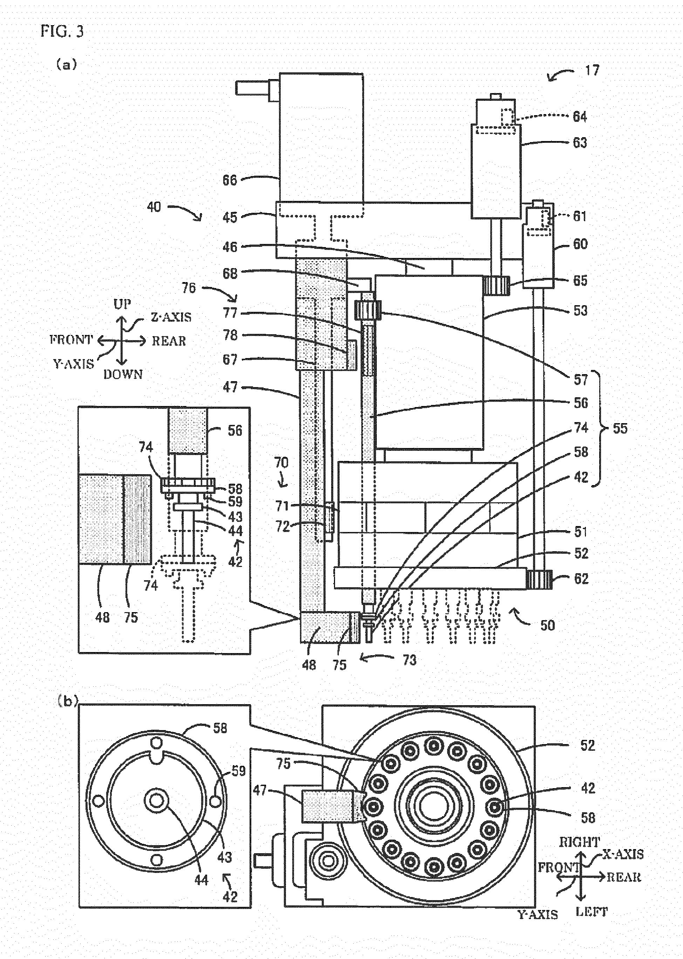

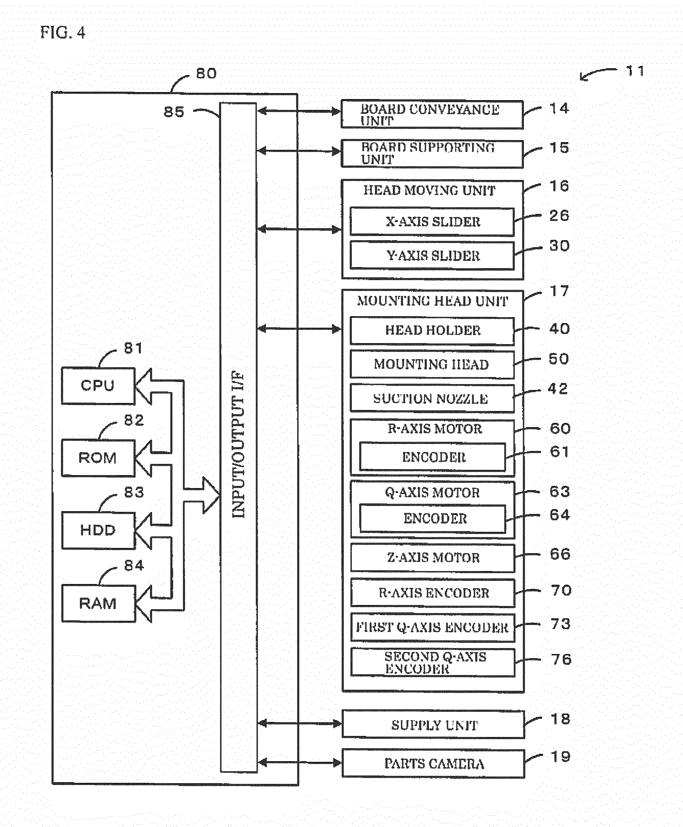

Hereinafter, an embodiment of the present invention will be described with reference to the figures. Fig. 1 is a view schematically illustrating a mounting system 10. Fig. 2 is a view schematically illustrating a mounting head unit 17. Fig. 3 is a view illustrating the mounting head unit 17 including a mounting head 50, Fig. 3(a) is a view on a side face side of the mounting head 50, and Fig. 3(b) is a view on a lower face side. Fig. 4 is a block diagram illustrating an electrical connection relationship of a mounting apparatus 11. The mounting system 10 of the embodiment includes the mounting apparatus 11 that performs a mounting process of a component P (refer to Fig. 2) on a board S and a management computer 90 that manages information on the mounting process (for example, production job data). In the embodiment, a left-right direction (X-axis), a front-rear direction (Y-axis), and an up-down direction (Z-axis) are as illustrated in Figs. 1 to 3. In addition, the mounting process includes processes of disposition, installation, insertion, bonding, adhesion, and the like of the component P on the board S.

The mounting apparatus 11 includes a board conveyance unit 14 that conveys the board S, a board supporting unit 15 that supports the board S from the lower face side, the mounting head unit 17 that suctions (picks up) the component P and disposes the component on the board S, and a head moving unit 16 that moves the mounting head unit 17 in X- and Y-directions (refer to Fig. 1). In addition, the mounting apparatus 11 includes a supply unit 18 in which a reel accommodating the component P is installed, a parts camera 19 that is capable of imaging the component P suctioned by a suction nozzle 42, a nozzle stocker 20 that accommodates multiple suction nozzles 42, and a control section 80 that performs various types of control (refer to Fig. 4).

The board conveyance unit 14 conveys the board S from left to right on conveyor belts 22 and 22 attached to a pair of front and rear support plates 21 and 21. The board supporting unit 15 includes multiple support pins 23 that support the board S from below and supports the board S from a rear face side of the board S conveyed and fixed by the board conveyance unit 14.

The head moving unit 16 includes an X-axis slider 26, a Y-axis slider 30, and the like. The X-axis slider 26 is attached to a front face of the Y-axis slider 30 that is slidable in the front-rear direction such that the X-axis slider is slidable in the left-right direction. The Y-axis slider 30 is slidably attached to a pair of right and left guide rails 32 and 32 extending in the front-rear direction. The guide rails 32 and 32 are fixed to the inside of the mounting apparatus 11. A pair of up and down guide rails 28 and 28 extending in the left-right direction are provided on the front face of the Y-axis slider 30, and the X-axis slider 26 is attached to the guide rails 28 and 28 so as to be slidable in the left-right direction. The mounting head unit 17 moves in the left-right direction along with the movement of the X-axis slider 26 in the left-right direction and moves in the front-rear direction along with the movement of the Y-axis slider 30 in the front-rear direction. The sliders 26 and 30 are driven by respective driving motors not illustrated.

The mounting head unit 17 is attached to the front face of the X-axis slider 26. The mounting head unit 17 includes a head holder 40 that is disposed on the X-axis slider 26 and holds the mounting head 50, suction nozzles 42 that suction the component P, and the mounting head 50 provided with one or more suction nozzles 42 which can be installed to and removed from the mounting head. As illustrated in Fig. 3, the head holder 40 includes a holder main body 45 that is attached to the X-axis slider 26 and an engagement shaft 46 disposed below the holder main body 45. The engagement shaft 46 is disposed to be axially rotatable below the holder main body 45 and is inserted into a bottomed hole formed at the center of the mounting head 50 (Q-axis gear 53) so as to engage with the mounting head 50. An R-axis motor 60, a Q-axis motor 63, and a Z-axis motor 66 that rotatably drive the mounting head 50 are disposed in the holder main body 45. The R-axis motor 60 is provided with an encoder 61 (refer to Fig. 3), and control of a basic rotational position is performed by using the encoder 61. The encoder 61 may be a transmission type optical encoder. The Q-axis motor 63 is similar to the R-axis motor 60 and includes an encoder 64. The Z-axis motor 66 moves a horizontal section 68 along a Z-axis guide 67 vertically elongated downward, thereby lifting and lowering the suction nozzles 42. A rotation axis of the mounting head 50 (rotary section 51) is referred to as an R-axis, and a rotation axis of the suction nozzles 42 (component holding section 55) is referred to as a Q-axis.

The head holder 40 holds the mounting head 50. For example, the mounting head 50 includes 16 component holding sections 55, and provided with 16 suction nozzles 42 which can be installed thereto (refer to Figs. 2 and 3). The mounting head 50 is configured as a rotary work head that is held by the head holder 40 in a rotatable state. The mounting head 50 includes the rotary section 51 which is a columnar member, an R-axis gear 52 disposed below the rotary section 51, the Q-axis gear 53 disposed above the rotary section 51, and multiple elongated cylindrical syringe members 56 having a lower end in which the suction nozzle 42 is installed. The mounting head 50 is provided with the component holding sections 55 that can be lifted and lowered and has the suction nozzles 42 which pick up the component P and the syringe members 56 which enable the suction nozzles 42 to be installed to and removed from. The mounting head 50 is held by the head holder 40 so as to be rotatable around the rotation axis (R-axis) and includes the rotary section 51 that has the central axis that is the same as the rotation axis. The rotary section 51 is a member that supports 16 syringe members 56 such that the syringe members are rotatable around the central axis of the syringe member 56 and are vertically movable. The R-axis gear 52 is a disc-shaped member having an outer diameter larger than that of the rotary section 51 and is provided with a gear groove formed in an outer peripheral surface thereof. The R-axis gear 52 meshes with a small gear 62 connected to the rotation axis of the R-axis motor 60 and is rotatably driven by the R-axis motor 60 via the small gear 62. The Q-axis gear 53 is a cylindrical member having an outer diameter smaller than that of the rotary section 51 and is provided with a gear groove formed in an outer peripheral surface thereof. The syringe member 56 is a member which is provided with a small gear 57 on an upper end side thereof and in which the suction nozzle 42 is installed on a lower end side thereof. The small gear 57 meshes with the gear groove formed on the outer circumference of the Q-axis gear 53. The syringe members 56 are disposed along the outer circumference of the Q-axis gear 53 at equal intervals.

The component holding sections 55 includes the suction nozzle 42, the syringe member 56, the small gear 57, a flange 58, and a code section 74. The component holding sections 55 is rotatable around the rotation axis (Q-axis) and is used to hold the component P. The suction nozzle 42 suctions the component P on the nozzle tip or releases the component P suctioned on the nozzle tip by using pressure. The suction nozzle 42 has a disc-shaped flange 43 and a pipe-shaped portion 44 formed on the tip side (refer to Figs. 2 and 3). Here, a holding member that picks up and holds the component P is described as the suction nozzle 42; however, as long as the holding member can hold the component P, the holding member is not particularly limited and the holding member may be a mechanical chuck that performs picking up and holding by pinching the component P. The component holding section 55 (suction nozzle 42) rotates around the rotation axis (Q-axis) and can adjust an angle of the suctioned component P with a drive power of the Q-axis motor 63 which is transmitted via the small gear 65, the Q-axis gear 53 and the small gear 57 disposed on the upper end side of the syringe members 56, which are connected to the Q-axis motor 63. When the Q-axis motor 63 rotates, all of the multiple component holding sections 55 rotate by the same angle. Therefore, rotational positions of the multiple component holding sections 55 are maintained in the same state as each other. The flange 58 is a disc-shaped member disposed on the lower end of the syringe member 56. A lower face of the flange 58 is provided with multiple (in the embodiment, four) fiducial marks 59 at equal intervals (interval of 90°) in a circumferential direction of the flange 58 (refer to Fig. 3(b)). The fiducial mark 59 is a columnar protruding section protruding down from the flange 58 (refer to Figs. 2 and 3) and has a circular shape when viewed from below. The fiducial mark 59 is imaged by the parts camera 19 and is used to detect the rotational position of the component holding section 55 based on a captured image. The code section 74 is a ring-shaped circular plate member disposed to be coaxial to the flange 58 or the Q-axis. The outer peripheral surface of the code section 74 is provided with a region in which light is reflected and a region in which the light is not reflected. The code section 74 is a part of a first Q-axis encoder 73, which will be described below, and is also used to detect the rotational position of the component holding sections 55 by using the first Q-axis encoder 73.

The component holding section 55 is lifted and lowered in the Z-axis direction (up-down direction) along the Z-axis guide 67 with the drive power of the Z-axis motor 66 which is transmitted via the horizontal section 68. In the mounting head 50, the component holding sections 55 are lifted and lowered in the Z-axis direction at one liftable/lowerable position on a front end side of the mounting head unit 17 in the Y-axis direction (refer to Fig. 3).

In front of the holder main body 45, a rectangular columnar support member 47 is disposed downward and supports an R-axis encoder 70, the first Q-axis encoder 73, a second Q-axis encoder 76, and the like as acquisition sections. The support member 47 extends to a position at which to be opposite to the code section 74 of the component holding sections 55. A horizontal section 48 is formed on the lower end side of the support member 47 toward the side of the component holding sections 55, and the first Q-axis encoder 73 is disposed on the tip of the horizontal section 48. The R-axis encoder 70 is the acquisition section that directly detects a rotational position of the mounting head 50 (rotary section 51) and acquires a value indicating the rotational position, and the encoder is configured as a reflection type optical encoder. The R-axis encoder 70 is disposed at a position at which to be opposite to the rotary section 51 as the cylindrical section of the mounting head 50. The R-axis encoder 70 includes a code section 71 formed over the central portion of the outer circumference of the rotary section 51 in the up-down direction and an element section 72 disposed at a position at which to be opposite to the code section 71 in the support member 47. The code section 71 is provided with a region in which light with which irradiation is performed from the element section 72 is reflected and a region in which the light is not reflected. The element section 72 has an irradiation section that performs irradiation with light and a light receiving section that receives light reflected from the code section 71. The R-axis encoder 70 irradiates the code section 71 with light from the element section 72 and detects a pattern of the reflected light from the code section 71, and thereby the rotational position of the rotary section 51 is known.

The first Q-axis encoder 73 is the acquisition section that detects a rotational position of the suction nozzle 42 installed on the lower end of the component holding section 55 and acquires a first rotation value indicating the rotational position, and the encoder is configured as a reflection type optical encoder. The first Q-axis encoder 73 includes the disc-shaped code section 74 attached to the component holding section 55 and an element section 75 disposed at a position at which to be opposite to the outer peripheral surface of the code section 74 in the support member 47. The first Q-axis encoder 73 has the element section 75 that is fixed to the support member 47 and is formed to be elongated in a lifting-lowering direction of the component holding sections 55 such that the element section is opposite to the code section 74 at both of an initial position (refer to a solid line in a balloon in Fig. 3(a)) which is a lifted position (component imaging position) of the suction nozzle 42 and a lowered position (refer to a dotted line in the same figure) of the suction nozzle 42 when the component holding section 55 is lifted and lowered. The second Q-axis encoder 76 is the acquisition section that directly detects a rotational position of the syringe member 56 in the vicinity of the small gear 57 on the upper end of the component holding section 55 and acquires a value indicating the rotational position, and the encoder is configured as a reflection type optical encoder. The second Q-axis encoder 76 is disposed in a cylindrical section of the syringe members 56 on the upper end side. The second Q-axis encoder 76 includes a code section 77 formed over the outer circumference of the syringe member 56 and an element section 78 disposed at a position at which to be opposite to the code section 77 in the support member 47. The code section 74, the code section 77, the element section 75, and the element section 78 have the same configuration as the code section 71 and the element section 72, and thus the description thereof is omitted. The element section 72 of the R-axis encoder 70, the element section 75 of the first Q-axis encoder 73, and the element section 78 of the second Q-axis encoder 76 are disposed to be opposite to the component holding sections 55 or the rotary section 51 from the outer circumferential side of the mounting head unit 17 (mounting head 50). The R-axis encoder 70, the first Q-axis encoder 73, and the second Q-axis encoder 76 are all configured as an absolute type encoder that is capable of detecting an absolute value of the rotational position. Specifically, the code section 71, the code section 74, and the code section 77 are formed to have unique patterns of the region in which light is reflected and the region in which light is not reflected, depending on the rotational positions (angles).

When the mounting head 50 rotates around the rotation axis (R-axis), the multiple component holding sections 55 move, and thereby the multiple component holding sections 55 and the first Q-axis encoder 73 (element section 75) relatively move with respect to each other. The first Q-axis encoder 73 (element section 75) is opposite to one component holding section 55 at a liftable/lowerable position of the multiple component holding sections 55, detects the rotational position thereof, and acquires a first rotation value. In other words, the mounting head 50 rotates around the R-axis, and thereby the mounting apparatus 11 can switch the component holding section 55 that is opposite to the first Q-axis encoder 73 (element section 75). The same is true of the second Q-axis encoder 76.

The parts camera 19 is disposed between the board conveyance unit 14 and the supply unit 18. An imaging range of the parts camera 19 is a region above the parts camera 19. When the mounting head 50 having the suctioned component P passes above the parts camera 19, the parts camera 19 images the component P suctioned by the suction nozzle 42 and the fiducial mark 59 from below and outputs the image to the control section 80.

As illustrated in Fig. 4, the control section 80 is configured as a microprocessor with a CPU 81 as a main unit and includes a ROM 82 that stores a processing program, a HDD 83 that stores various types of data, a RAM 84 used as a work region, and an input and output interface 85 that transmits and receives an electric signal to and from an external device. The units are connected via a bus. The control section 80 is connected to the board conveyance unit 14, the board supporting unit 15, the head moving unit 16, the mounting head unit 17, the supply unit 18, the parts camera 19, and the like such that bidirectional communication can be performed therebetween, and thereby the control section transmits and receives a signal to and from the units. The control section 80 detects the rotational position of the component P in the image and acquires a component rotation value indicating the rotational position based on the image captured by the parts camera 19, and detailed description thereof will be provided below. In addition, the control section 80 detects the rotational position of the component holding section 55 based on the fiducial mark 59 in the image and acquires a second rotation value indicating the rotational position. As described above, the mounting apparatus 11 of the embodiment acquires, as values indicating the rotational position of the component holding section 55, two values of a first rotation value that is acquired by the first Q-axis encoder 73 and a second rotation value that is acquired by using the parts camera 19 and the control section 80.

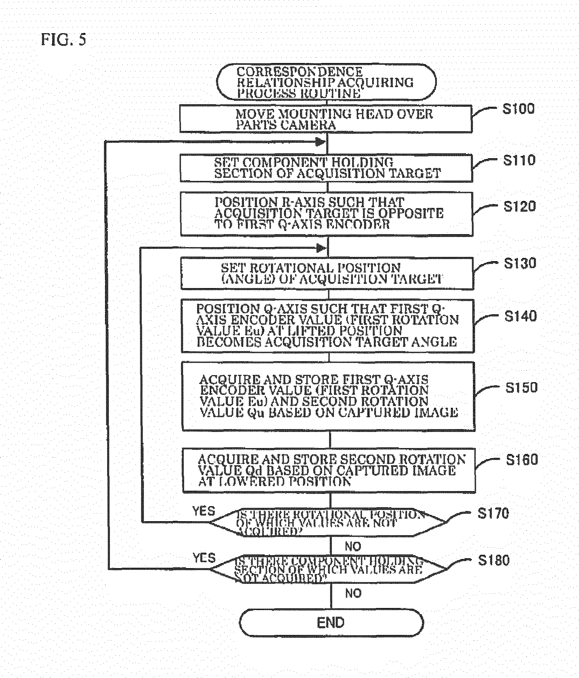

Next, an operation of the mounting system 10 of the embodiment having such a configuration will be described. First, a process in which the CPU 81 of the control section 80 acquires a correspondence relationship between the first rotation value and the second rotation value of the component holding section 55 by using the first Q-axis encoder 73 and the parts camera 19 is described. Fig. 5 is a flowchart illustrating an example of the correspondence relationship acquiring process routine performed by the CPU 81 of the control section 80. The routine is stored in the HDD 83 and is performed at a predetermined timing such as when the mounting apparatus 11 is used for the first time or when an operator inputs an instruction via an operation panel (not illustrated). In the routine, for each of the multiple component holding sections 55, the component holding section 55 is rotated around the Q-axis, and a correspondence relationship between the first rotation values and the second rotation values is acquired for the multiple rotational positions.

When the correspondence relationship acquiring process routine is started, the CPU 81 of the control section 80 first moves the mounting head 50 over the parts camera 19 (Step S100). Subsequently, the CPU 81 sets a component holding section 55 of an acquisition target of the correspondence relationship from the multiple component holding sections 55 (Step S110). Next, the CPU 81 rotates the mounting head 50 around the R-axis and performs positioning of the component holding section 55 of the acquisition target such that the component holding section 55 is positioned at a position (liftable/lowerable position) to be opposite to the first Q-axis encoder 73 (Step S120). The CPU 81 controls drive of the R-axis motor 60 such that the rotary section 51 has a predetermined rotational position by using a value of the encoder 61 provided on the R-axis motor 60, thereby performing the positioning.

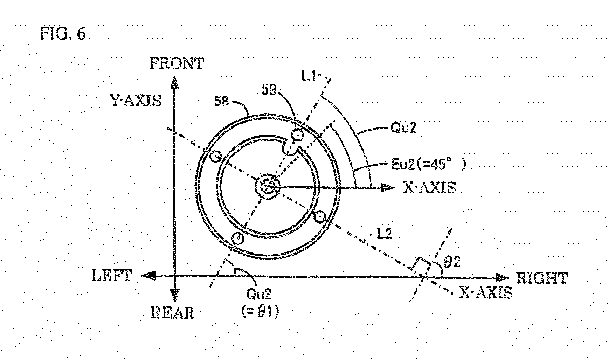

Subsequently, the CPU 81 sets a rotational position (acquisition target angle) of the acquisition target of the first rotation value and the second rotation value (Step S130). In the embodiment, the CPU 81 first sets the acquisition target angle as 0°, and sets the acquisition target angles of 45°, 90°,..., and 315° in this order at an equal interval (interval of 45°). In the embodiment, the right direction of the X-axis is set as a reference of the angle (0°) in the mounting apparatus 11. Next, in a state in which the component holding section 55 is positioned at the lifted position, the CPU 81 controls drive of the Q-axis motor 63 and performs positioning of the rotation of the component holding section 55 around the Q-axis such that a first rotation value Eu acquired by the first Q-axis encoder 73 is the acquisition target angle set in Step S130 (Step S140). The first rotation value at the lifted position is referred to as the first rotation value Eu. In this state, the CPU 81 causes the parts camera 19 to image the component holding section 55, acquires the first rotation value Eu (acquisition target angle) detected by the first Q-axis encoder 73 and a second rotation value Qu based on the captured image, and stores the values in an associated manner in the HDD 83 (Step S150). The second rotation value acquired based on the captured image at the lifted position is referred to as the second rotation value Qu. Fig. 6 is a view illustrating a relationship between the first rotation value and the second rotation value. Fig. 6 illustrates a relationship between the first rotation value Eu2 and the second rotation value Qu2 in a case where the acquisition target angle is 45°. As illustrated in the figure, the captured image contains four fiducial marks 59 disposed on the lower face of the flange 58. The CPU 81 detects the four fiducial marks 59 contained in the captured image through an image processing and acquires the second rotation value Qu based on the positions of the detected fiducial marks 59. For example, the CPU 81 first identifies straight lines L1 and L2 which intersect with each other through two fiducial marks 59 based on the four detected fiducial marks 59. Next, the CPU 81 derives an angle θ1 which is an angle formed between a direction (right direction of the X-axis) which is the reference of the angle and the straight line L1 and an angle θ2 which is an angle obtained by subtracting 90° from an angle formed between the direction (right direction of the X-axis) which is the reference of the angle and the straight line L2. The CPU 81 derives an average value of the angle θ1 and the angle θ2 and acquires the derived value as the second rotation value Qu (a second rotation value Qu2 in Fig. 6). The angle θ1 and the angle θ2 have substantially the same value and, ideally, the angle θ1 = the angle θ2 = the second rotation value Qu. Fig. 6 illustrates the second rotation value Qu2 when the angle θ1 and the second rotation value Qu2 are substantially equal, for convenience of description. In addition, the CPU 81 may set the derived angle θ1 as it is as the second rotation value Qu without deriving the angle θ2. Here, when the component holding sections 55 have the same rotational position, ideally, the acquired first rotation value Eu and the second rotation value Qu have the same value. However, due to an attachment error of the code section 74, an eccentric shape of the code section 74, positional deviations (scale errors) when a pattern of the code section 74 is formed, or the like, deviations in the first rotation value Eu and the second rotation value Qu slightly occur and the same value is not obtained in some cases (refer to Fig. 6). The CPU 81 acquires the first rotation value Eu and the second rotation value Qu at the same rotational position and stores the values in the HDD 83 such that rotation control of the component holding sections 55 is performed by adding such deviations (errors). Significant deviations in the first rotation value Eu and the second rotation value Qu do not usually occur. Therefore, when the second rotation value Qu2 is acquired in Fig. 6, of two straight lines that pass through the detected four fiducial marks 59, a straight line having an angle formed with the direction (right direction of the X-axis) as the reference of the angle, with the angle close to the first rotation value Eu2, may be referred to as the straight line L1, and the other straight line may be referred to as the straight line L2. In addition, when the angle θ1 of the straight line L1 is derived, a value which is different by 180° is derived as the angle θ1 depending on whether an orientation of the straight line L1 is in an upper right direction or in a lower left direction in Fig. 6; however, even in this case, a value closer to the first rotation value Eu2 may be set as the angle θ1. Similarly, when the angle θ2 of the straight line L2 is derived, a value which is different by 180° is derived as the angle θ2 depending on whether an orientation of the straight line L2 is in a lower right direction or in an upper left direction in Fig. 6; however, even in this case, a value closer to the first rotation value Eu2 may be set as the angle θ2. In addition, in a case where a reference direction (for example, the right direction in an image) of an angle in an image captured by the parts camera 19 is deviated by a camera angle C from the direction (right direction of the X-axis) as the reference of the angle described above, the CPU 81 may derive the second rotation value Qu by performing correction by using the camera angle C. The camera angle C may be stored in the HDD 83 as a predetermined value.

Subsequently, the CPU 81 controls the drive of the Z-axis motor 66 and lowers the component holding section 55 to a lowered position, acquires a second rotation value Qd based on an image captured by the parts camera 19 similarly in Step S 150, and stores the value acquired in Step S150 in an associated manner in the HDD 83 (Step S160). The second rotation value acquired based on the captured image at the lowered position is referred to as the second rotation value Qd. Here, in a case where the component holding sections 55 are lifted and lowered without being rotated, ideally, the second rotation value Qu and the second rotation value Qd have the same value. However, due to a structure of lifting or rotation of the horizontal section 68, the small gear 57, and the like, the rotational position of the component holding section 55 is slightly deviated in some cases when the component holding section 55 is lifted and lowered. The CPU 81 acquires the second rotation value Qd obtained in a lowered state and stores the first rotation value Eu and the second rotation value Qu in an associated manner in the HDD 83 such that rotation control of the component holding sections 55 is performed by adding such deviations (errors) of the rotational position.

In this manner, when the first rotation value Eu, the second rotation value Qu, and the second rotation value Qd are acquired, the CPU 81 determines whether or not there is a rotational position of which the values are not acquired (Step S170) and performs processes from Step S130 onward in a case where there is a rotational position of which the values are not acquired. In other words, the acquisition target angle is changed by 45°, and correspondence relationships between the first rotation values Eu, the second rotation values Qu, and the second rotation values Qd are sequentially acquired at the acquisition target angles. In a case where there is no rotational position of which the values are not acquired in Step S170, the CPU 81 determines whether or not there is a component holding section 55 of which the correspondence relationship is not acquired (Step S180) and performs processes from Step S110 onward in a case where there is a component holding section 55 of which the correspondence relationship is not acquired. In other words, any unit of the component holding sections 55, of which the correspondence relationship is not acquired, is set as an acquisition target of the correspondence relationship, and the first rotation values Eu, the second rotation values Qu, and the second rotation values Qd are acquired at the acquisition target angles. In a case where there are no component holding sections 55 of which the correspondence relationship is not acquired in Step S180, the CPU 81 ends the routine.

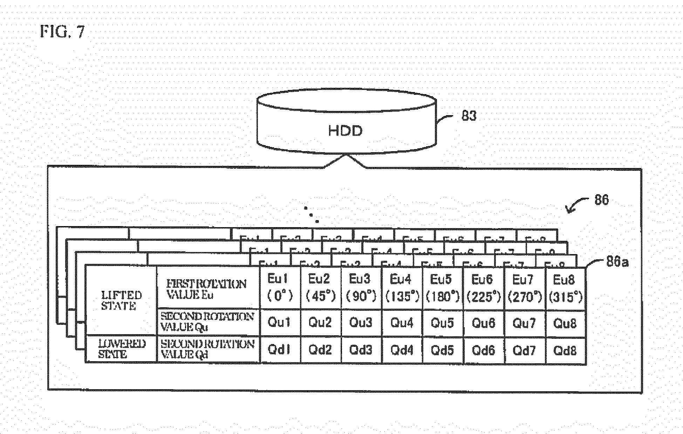

The correspondence relationship acquiring process routine is performed, and thereby the CPU 81 acquires correspondence relationship information 86 illustrated in Fig. 7 and stores the information in the HDD 83. The correspondence relationship information 86 contains multiple types of correspondence relationship information 86a. The various types of correspondence relationship information 86a is a table in which the first rotation values Eu (Eu1 to Eu8), the second rotation values Qu (Qu1 to Qu8), and the second rotation values Qd (Qd1 to Qd8) are associated with each other for each acquisition target angle in each of the multiple component holding sections 55. In the correspondence relationship information 86, values corresponding to each other have the same value of the values 1 to 8 at the end. For example, in the correspondence relationship information 86a, the first rotation value Eu1, the second rotation value Qu1, and the second rotation value Qd1 are values which are all acquired in a case where the acquisition target angle is 0° and are all associated with each other.

Next, a mounting process in which the mounting apparatus 11 mounts the component P on the board S will be described. A mounting process routine is stored in the HDD 83 of the control section 80 and is performed with a production start instruction by an operator. When the routine is performed, the CPU 81 conveys the board S into the apparatus and controls the board conveyance unit 14 and the board supporting unit 15 such that the board is fixed at the mounting position. Next, the CPU 81 reads the production job data, sets the component P of a mounting target that is disposed on the board S, and performs a process of installing the mounting head 50 and the suction nozzles 42, which pick up the component P, in the head holder 40. Next, the CPU 81 controls the head moving unit 16, the mounting head unit 17, and the parts camera 19, causes the suction nozzle 42 to pick the component P, and causes the component picking and disposition process of performing disposition on the board S. When the mounting process of the current board is ended, the board S is unloaded, the next board S is loaded, and the board is fixed to a mounting position. The CPU 81 repeatedly performs the processes described above until the production of all of the boards is finished.

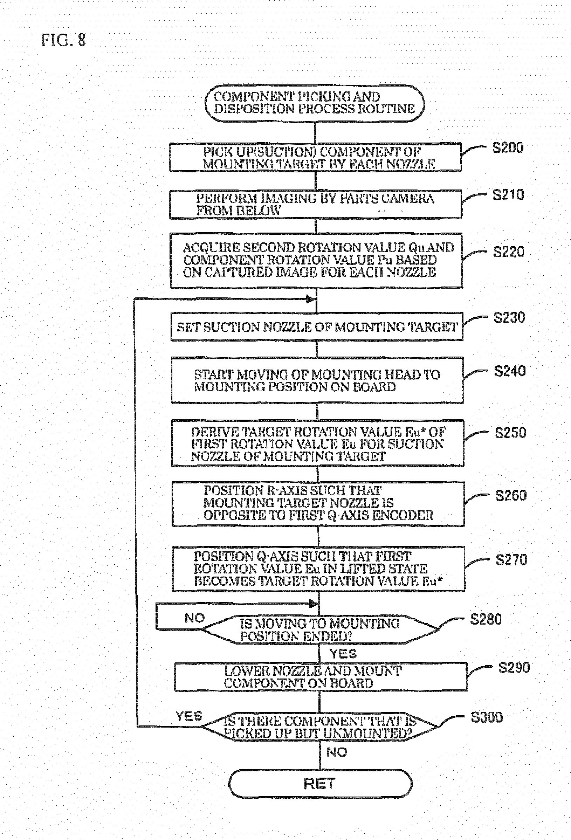

Subsequently, the component picking and disposition process performed in the mounting process routine will be described in detail. Fig. 8 is a flowchart illustrating an example of the component picking and disposition process routine that is performed by the CPU 81 of the control section 80. The routine is stored in the HDD 83 and is performed at a predetermined timing.

When the component picking and disposition process routine is started, the CPU 81 of the control section 80 first causes each of the multiple suction nozzles 42 to pick up the component P of the mounting target (Step S200). In the process, after the mounting head unit 17 is disposed at the component picking position of the supply unit 18 for which the production job data is designated, the CPU 81 drives the Z-axis motor 66 such that the suction nozzle 42 is lowered to the lowered position and applies negative pressure to the suction nozzle 42 such that the component P is suctioned at the tip. In addition, the CPU 81 rotates the mounting head 50 around the R-axis, switches the suction nozzle 42 positioned at the liftable/lowerable position, and causes the multiple suction nozzle 42 to suction the components P.

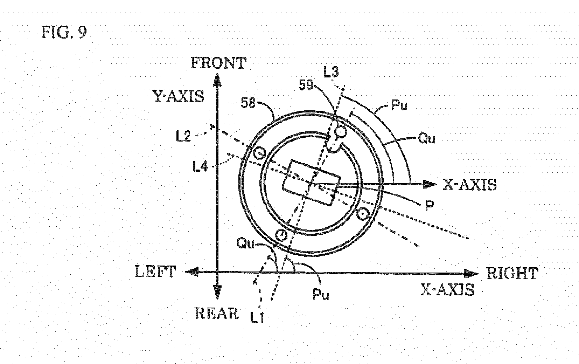

Subsequently, the CPU 81 moves the mounting head 50 over the parts camera 19, and causes the parts camera 19 to capture the image of the mounting head 50 from below (Step S210). In this manner, an image containing the fiducial marks 59 disposed at each of the multiple component holding sections 55 and the component P picked up by each of the multiple suction nozzles 42 is captured. The CPU 81 acquires the second rotation value Qu and a component rotation value Pu based on the captured image in a state in which the component holding section 55 (suction nozzle 42) holds the component P and stores the values in the HDD 83 (Step S220). The component rotation value acquired based on the captured image at the lifted position of the component holding section 55 is referred to as the component rotation value Pu. In addition, the second rotation value Qu and the component rotation value Pu are acquired for each of the multiple component holding sections 55. Fig. 9 is a view illustrating an example of acquiring the second rotation value Qu and the component rotation value Pu in one component holding section 55. Similar to Step S150 of the correspondence relationship acquiring process routine, the CPU 81 detects the four fiducial marks 59 contained in the captured image and acquires the second rotation value Qu based on the result of detection. Similar to Step S150 described above, the CPU 81 determines the straight lines L1 and L2 and derives the angles θ1 and θ2 based on a value (angle) of the first rotation value Eu detected by the current first Q-axis encoder 73 and acquires the second rotation value Qu. In addition, the CPU 81 detects the component P contained in the captured image and acquires the component rotation value Pu based on the result of the detection. For example, the CPU 81 detects an outline of the component P or detects a specific part (fiducial mark or the like) of the component P. In this manner, the component rotation value Pu of the component P is acquired based on the detected part. In the embodiment, the CPU 81 first identifies a straight line L3, which is perpendicular to a long side of the component P, as a straight line which is the reference of the rotational position. The CPU 81 acquires the component rotation value Pu as an angle formed between the direction (right direction of the X-axis) which is the reference of the angle and the straight line L3. In the embodiment, as the production job data, the rotational position of the component holding section 55 is designated as the rotational position at which the first rotation value Eu and the component rotation value Pu become the same value when the component is picked up in Step S200. The CPU 81 performs picking up of the component P in a state in which the component holding sections 55 is rotated around the Q-axis such that the first rotation value Eu is the designated rotational position. Therefore, the second rotation value Qu and the component rotation value Pu which are acquired in Step S220 are ideally the same value as the current first rotation value Eu. However, due to deviations in the first rotation value Eu and the second rotation value Qu or a positional deviation of the component P supplied from the supply unit 18, the second rotation value Qu and the component rotation value Pu which are obtained in Step S220 are not the same value in some cases (refer to Fig. 9). The CPU 81 acquires each of the second rotation value Qu and the component rotation value Pu such that rotation control of the component holding sections 55 is performed by adding such deviations (errors). Significant deviations in the first rotation value Eu, the second rotation value Qu, and the component rotation value Pu do not usually occur. Therefore, the component rotation value Pu is derived as a value which is different by 180° depending on whether an orientation of the straight line L3 is in an upper right direction or in a lower left direction in Fig. 9; however, a value closer to the first rotation value Eu (or the second rotation value Qu) may be set as the component rotation value Pu. In addition, similar to the derivation of the second rotation value Qu, the CPU 81 may derive the component rotation value Pu based on two straight lines (for example, the straight line L3 and a straight line L4 that is perpendicular to short side of the component P) which are identified based on the component P.

As described above, when the CPU 81 acquires the second rotation value Qu and the component rotation value Pu for each of the multiple component holding sections 55 in Step S220, the CPU 81 sets a component holding section 55 (suction nozzle 42) of the next mounting target of the multiple component holding sections 55 that hold the component (Step S230), and starts movement of the mounting head 50 toward the mounting position of the component (a position at which the component is disposed) on the board S (Step S240). The CPU 81 derives a target rotation value Eu* of the first rotation value Eu for the suction nozzle 42 of the mounting target by which the component P has a target posture Pd* at the lowered position of the component holding sections 55 (Step S250). Specifically, the CPU 81 first derives a difference D between the component rotation value Pu and the second rotation value Qu which are acquired in Step S220. Next, a difference between the derived difference D and the target posture Pd* of the component P which is contained in the production job data is derived, and the derived value is used as a target value Qd* of the second rotation value Qd during the lowering. The target value Qd* is a value corresponding to the second rotation value Qd obtained in a state in which the component holding section 55 is rotated such that the component rotation value Pu becomes the target posture Pd*. In other words, if the component holding section 55 is rotated such that the second rotation value Qd obtained during the lowering of the component holding section 55 becomes the target value Qd*, the rotational position of the component P becomes the target posture Pd*. Next, the CPU 81 derives a value of the second rotation value Qu during the lifting, which corresponds to the target value Qd*, based on the correspondence relationship information 86 stored in the HDD 83, and the derived value becomes the target value Qu*. In the correspondence relationship information 86, a correspondence relationship between the second rotation value Qu and the second rotation value Qd for each of the multiple component holding sections 55 as illustrated in Fig. 7. The CPU 81 derives a value of the second rotation value Qu corresponding to the target value Qd* (second rotation value Qd) by using the correspondence relationship of the component holding sections 55 of the mounting target of the correspondence relationship information 86, and the obtained value becomes the target value Qu*. The correspondence relationship information 86 exists only as data of the correspondence relationship between eight points acquired by changing an angle by 45° as illustrated in the figure, correspondence relationships at angles between the points are derived from known linear interpolation. For example, when the target value Qd* is a value between a second rotation value Qd1 and a second rotation value Qd2, the target value Qu* is derived from Equation (1). Instead of the linear interpolation, other types of interpolation such as polynomial interpolation, zero-order interpolation (nearest neighbor interpolation) may be used. The derived target value Qu* is a value corresponding to the second rotation value Qu at the lifted position, by which deviations in the second rotation value Qd and the second rotation value Qu described above are added and the second rotation value Qd obtained at the lowered position becomes the target value Qd*.

$$Qu^* = Qu1 + (Qu2 - Qu1) \times (Qd^* - Qd1)/(Qd2 - Qd1) \ (1)$$

The CPU 81 derives a value of the first rotation value Eu corresponding to the target value Qu* based on the correspondence relationship information 86, and the derived value becomes the target rotation value Eu*. Similar to the deriving of the target value Qu* corresponding to the target value Qd*, it is possible to derive the value of the target rotation value Eu* corresponding to the target value Qu*, based on the correspondence relationship between the first rotation value Eu and the second rotation value Qu in the correspondence relationship information 86. The derived target rotation value Eu* is a value corresponding to the first rotation value Eu at the lifted position, by which deviations in the first rotation value Eu and the second rotation value Qu described above are added and the second rotation value Qu obtained at the lifted position becomes the target value Qu*. In addition, the derived target rotation value Eu* corresponds to a value of a first rotation value Eu1 of the component holding section 55 at the lifted position, which corresponds to the second rotation value Qd (= the target value Qd*) of the component holding sections at the lowered position, by which the component P has the target posture Pd* of the component holding section 55 at the lowered position. As described above, the CPU 81 derives, by using the correspondence relationship information 86, a value of the first rotation value Eu (target rotation value Eu*) by which deviations in the first rotation value Eu and the second rotation value Qd or deviations in the second rotation value Qd and the second rotation value Qu are added and the component P has the target posture Pd* at the lowered position.

Subsequently, similar to Step S120, the CPU 81 rotates the mounting head 50 around the R-axis and performs positioning of the component holding section 55 such that the component holding section 55 of the mounting target is positioned at a position (liftable/lowerable position) at which to be opposite to the first Q-axis encoder 73 (Step S260). Next, in a state in which the component holding section 55 is positioned at the lifted position, the CPU 81 controls drive of the Q-axis motor 63 and performs positioning of the rotation of the component holding section 55 around the Q-axis such that the first rotation value Eu acquired by the first Q-axis encoder 73 becomes the target rotation value Eu* derived in Step S250 (Step S270). The CPU 81 is in a standby state until movement of the mounting head 50 is ended at the mounting position of the component on the board S (Step S280), and maintains the standby state when the movement to the mounting position is not ended. When the movement of the mounting head 50 is ended at the mounting position, the CPU 81 lowers the component holding sections 55 and performs a mounting process (disposition process) of the component P (Step S290). The CPU 81 determines whether or not a component P, which is picked up and is not mounted by the mounting head 50, is present in the mounting head 50 (Step S300). When the component P, which is picked up and is not mounted, is present in the mounting head 50, the processes from Step S230 onward are repeatedly performed. In other words, the component holding section 55 (suction nozzle 42) of the next mounting target is set, the target rotation value Eu* is derived, and the mounting of the component P is performed. On the other hand, when the component P, which is picked up and is not disposed, is not present, the CPU 81 ends the routine as it is. Until the mounting of the components P is ended for the entire board S, the CPU 81 repeatedly performs such processes.

Here, a correspondence relationship between constituent elements of the embodiment and constituent elements of the present invention is clearly known. The component holding section 55 of the embodiment corresponds to a component holding section of the present invention, the first Q-axis encoder 73 corresponds to a first acquisition section, the parts camera 19 and the control section 80 correspond to a second acquisition section and a third acquisition section, and the control section 80 corresponds to a correspondence relationship acquisition section, a target rotation value deriving section, and a rotation control section. In addition, the code section 74 corresponds to a cylindrical section.

According to the mounting apparatus 11 of the embodiment described above, the CPU 81 acquires the correspondence relationship information 86 between the first rotation value Eu and the second rotation value Qu indicating the rotational position of the component holding section 55 by using the first Q-axis encoder 73 and the parts camera 19. In addition, the first rotation value Eu corresponding to the second rotation value Qu (= target value Qu*) is derived as the target rotation value Eu*, by which the component P has the target posture Pd*, based on the correspondence relationship information 86 and the second rotation value Qu and the component rotation value Pu obtained in a state in which the component holding section 55 holds the component. The component holding section 55 is rotated such that the first rotation value Eu acquired by the first Q-axis encoder 73 becomes the target rotation value Eu*. As described above, the correspondence relationship between the first rotation value Eu and the second rotation value Qu is acquired in advance, and the second rotation value Qu and the component rotation value Pu are acquired in a state in which the component holding section 55 holds the component P. In this manner, since it is possible to identify correspondence between the first rotation value Eu and the component rotation value Pu in the state of holding the component P, it is possible to derive the first rotation value Eu, that is, the target rotation value Eu*, by which the component P has the target posture Pd*, with higher accuracy. The component holding section 55 is rotated such that the first rotation value Eu acquired by the first Q-axis encoder 73 becomes the target rotation value Eu*, and thereby it is possible to position the posture of the held component P with higher accuracy.

In addition, the second acquisition section (the parts camera 19 and the control section 80) serves as the third acquisition section and has the parts camera 19 that is capable of imaging the fiducial mark 59 and the component P held by the component holding sections 55 simultaneously from a direction (below) along the rotation axis (Q-axis). The control section 80 acquires the second rotation value Qu and the component rotation value Pu based on the captured image. Hence, since it is possible to acquire the second rotation value Qu and the component rotation value Pu based on the same image, it is possible to measure a relative positional relationship between the component holding section 55 and the component P (for example, a difference between the acquired second rotation value Qu and component rotation value Pu). In addition, it is possible to acquire the second rotation value Qu and the component rotation value Pu with high efficiency.

Further, the control section 80 performs acquiring the first rotation values Eu and the second rotation values Qu multiple times (eight times) by changing the rotational position of the component holding section 55 and acquires the correspondence relationship information 86 based on results of the acquiring. Therefore, even in a case where the correspondence relationship between the first rotation value Eu and the second rotation value Qu is changed depending on the rotational position, it is possible to acquire the correspondence relationship information 86 to which the correspondence relationship is added. In other words, it is possible to acquire the correspondence relationship information 86 with higher accuracy. Therefore, it is possible to position the posture of the held component P with higher accuracy.

In the mounting apparatus 11, the component holding section 55 is capable of being lifted and lowered, and the control section 80 acquires, as the correspondence relationship information 86, a correspondence relationship between the first rotation value Eu of the component holding section 55 at the lifted position and the second rotation value Qd of the component holding section 55 at the lowered position. In addition, the control section 80 derives, as the target rotation value Eu*, the first rotation value Eu of the component holding section 55 at the lifted position, which corresponds to the second rotation value Qd (= target value Qd*) of the component holding section 55 at the lowered position, by which the component P of the component holding section 55 at the lowered position has the target posture Pd*, based on the correspondence relationship information 86 and the second rotation value Qu and the component rotation value Pu obtained in a state in which the component holding section 55 holds the component P. The control section 80 rotates the component holding section 55 such that the first rotation value Eu acquired by the first Q-axis encoder 73 becomes the target rotation value Eu* of the component holding section 55 at the lifted position. In this manner, even in a case where deviations in the rotational positions of the component holding section 55 occur at the lifted position and the lowered position, it is possible to derive the target rotation value Eu* of the component holding section 55 at the lifted position by adding the deviations by using the correspondence relationship information 86. Hence, it is possible to position the posture of the component P at the lowered position of the component holding section 55 with higher accuracy. When the component holding section 55 is lowered in a state of holding the component P, the component P abuts on the board S, and thus it is not preferable that the component holding section 55 is rotated at the lowered position. In this respect, in the mounting apparatus 11 of the embodiment, it is possible to determine, as a value (target rotation value Eu*) of the first rotation value Eu at the lifted position, the rotational position at which the component P at the lowered position has the target posture Pd*. Hence, the component holding section 55 is not rotated at the lowered position, and it is possible to position the posture of the component P at the lowered position with higher accuracy.

Also, in the mounting apparatus 11, the multiple component holding sections 55 are provided, and the multiple component holding sections 55 and the first Q-axis encoder 73 are capable of performing relative movement with respect to each other such that it is possible to switch the component holding section 55 that is opposite to the first Q-axis encoder 73 through the relative movement. In addition, the first Q-axis encoder 73 acquires the first rotation value Eu of the opposite component holding section 55 (code section 74). The control section 80 acquires the correspondence relationship information 86 for each of the multiple component holding sections 55 and derives the target rotation value Eu* for each of the multiple component holding sections 55. The control section 80 rotates the component holding section 55 such that the first rotation value Eu acquired for each of the multiple component holding sections 55 by the first Q-axis encoder 73 becomes the target rotation value Eu*. As described above, in a case where one of the multiple component holding sections 55 that is opposite to the first Q-axis encoder 73 is switched through the relative movement and the first rotation value Eu is acquired, it is not possible to continually acquire the first rotation values Eu of one component holding section 55. For example, due to the rotation around the R-axis performed after capturing of an image of the component P in Step S210 until the component holding section 55, which holds the component, moves to the liftable/lowerable position, deviations in the rotational position of the component holding section 55 regardless of an operation of the Q-axis motor 63 occur in some cases; however, it is not possible to detect such deviations by only the first Q-axis encoder 73. Even in such a case, the mounting apparatus of the present invention can identify correspondence between the first rotation value Eu and the component rotation value Pu based on the correspondence relationship information 86 acquired in advance and the second rotation value Qu acquired in a state in which the component holding section 55 holds the component. Therefore, it is possible to position the posture of the held component P with higher accuracy. Hence, application of the present invention to such a case has a great significance.

Also, in the mounting apparatus 11, the component holding section 55 is provided with a cylindrical section (code section 74), and the first Q-axis encoder 73 is disposed at the position opposite to the outer peripheral surface of the code section 74 of the component holding section 55 and acquires the first rotation value Eu of the opposite component holding section 55. Therefore, it is easy to acquire the first rotation value Eu.

The present invention is not limited to the embodiments described above, and may be embodied as various aspects within the scope of the claims of the present invention.

For example, in the embodiment described above, the fiducial mark 59 is detected, based on the image captured by the parts camera 19 and the second rotation value Qu is acquired; however, the embodiment is not limited thereto, as long as it is possible to acquire the second rotation value Qu. For example, one of the multiple fiducial marks 59 may have a different shape from the other fiducial marks 59 such that it may be easy to acquire (measure) the second rotation value Qu. Alternatively, one fiducial mark, with which the orientation of the rotation can be determined, may be disposed on the lower face of the flange 58, and the second rotation value Qu may be acquired by using the orientation of the fiducial mark. In addition, the fiducial mark 59 is formed of a columnar member; however, for example, a pattern or the like disposed on the lower face of the flange 58 may be the fiducial mark. In addition, in Step S210, the CPU 81 causes the parts camera 19 to image the fiducial marks 59 and the component P simultaneously; however, as long as the component holding section 55 is in the state of holding the component P, the fiducial mark 59 and the component P may be captured on separate images. The CPU 81 may cause the capturing of the separate images to be performed for each of the multiple component holding sections 55.

In the embodiment described above, the CPU 81 acquires the first rotation value Eu and the second rotation value Qu eight times in the correspondence relationship acquiring process routine, by changing the rotational position of the component holding section 55 at an interval of 45°; however, the embodiment is not limited thereto. It is possible to appropriately determine the number of times of the acquiring or the interval of an angle depending on a period of time taken for the acquisition or accuracy required for the acquisition. For example, the CPU 81 may acquire the first rotation value Eu and the second rotation value Qu 360 times by changing the acquisition target angle of the component holding section 55 by 1°. In addition, the CPU 81 may acquire the first rotation value Eu and the second rotation value Qu only once for one component holding section 55. In this manner, it is also possible to add all of the deviations of the first rotation value Eu and the second rotation value Qu (such as a deviation of 5° even at any rotational position). However, since there is a case where a deviation amount of the first rotation value Eu and the second rotation value Qu is different depending on the rotational position, such as a case where the code section 74 has a scale error, it is preferable that the first rotation value Eu and the second rotation value Qu are acquired multiple times. The same is true of the second rotation value Qd.

A method of deriving the target rotation value Eu* by the CPU 81 in Step S250 in the embodiment described above is not limited to the example described above. As a result, the target rotation value Eu* by which the component P has the target posture Pd* may be derived. For example, in the embodiment described above, the CPU 81 derives the target value Qu* in a process of deriving the target rotation value Eu*; however, the process may be omitted. Specifically, the target rotation value Eu* corresponding to the target value Qd* may be directly derived, based on a relationship between the first rotation value Eu and the second rotation value Qd contained in the correspondence relationship information 86. In this case, the correspondence relationship information 86 may not contain the value of the second rotation value Qu.

In the embodiment described above, the second rotation value Qd at the lowered position is acquired in Step S160; however, such a process may be omitted. In other words, the correspondence relationship between the first rotation value Eu and the second rotation value Qu may be acquired in the correspondence relationship acquiring process routine. In this case, no deviation in the rotational position depending on the lifting and lowering of the component holding section 55 is considered, and the first rotation value Eu corresponding to a component posture Pu* (= component posture Pd*) at the lifted position may be derived as the target rotation value Eu*. In this manner, it is also possible to position the posture of the component P with high accuracy by adding the deviations in the first rotation value Eu and the second rotation value Qu.

In the embodiment described above, the mounting head 50 is a rotary work head that is capable of rotating the multiple component holding sections 55 around the R-axis. The mounting head 50 may include only one component holding section 55.

In the embodiment described above, the CPU 81 acquires the second rotation value Qd at a predetermined lowered position in Step S160 of the correspondence relationship acquiring process routine; however, the second rotation value may be acquired at multiple lowered positions having different heights from each other. In other words, the CPU 81 may acquire, as the correspondence relationship information 86, the correspondence relationship between the first rotation value Eu of the component holding section 55 at the lifted position and the second rotation values of the component holding section 55 at the multiple lowered positions. In Step S250, the CPU 81 may identify the second rotation value at the lowered position having the same height as the lowered position of the component holding section 55 when disposition on the board S (mounting) is performed (lowered position during the mounting), of the second rotation values at the multiple lowered positions which are contained in the correspondence relationship information 86, and the CPU may derive the target rotation value Eu* corresponding to the target value Qd* based on a correspondence relationship between the identified second rotation value and the first rotation value Eu. In this manner, even in a case where the lowered position during the mounting is changed depending on the component P, it is possible to derive the target rotation value Eu* corresponding to the lowered position during the mounting, and thus it is possible to position the posture of the component P at the lowered position during the mounting with high accuracy. In a case where the lowered position during the mounting is different from any one of the multiple lowered positions associated with the correspondence relationship information 86, the target rotation value Eu* corresponding to the target value Qd* may be derived, based on a correspondence relationship between the first rotation value Eu and the second rotation value at the lowered position that is closest to the lowered position during the mounting. Alternatively, the second rotation value at the same lowered position as the lowered position during the mounting may be derived by using interpolation such as the linear interpolation, based on the correspondence relationship information 86, and the target rotation value Eu* corresponding to the target value Qd* may be derived, based on the correspondence relationship between the derived value and the first rotation value Eu. In a case where the second rotation value at the lowered position during the mounting is derived by using the linear interpolation, it is possible to perform the deriving as long as two or more correspondence relationships between the second rotation value Qu at the lifted position and the second rotation values at the multiple lowered positions are known. For example, even in a case where only the correspondence relationship between the second rotation value Qu at the lifted position and the second rotation value Qd at one lowered position is known as similar to the correspondence relationship information 86 in Fig. 7, it is possible to derive the second rotation value at the lowered position during the mounting, which is different from the lowered position, by using the linear interpolation. It is possible to derive the target rotation value Eu* corresponding to the target value Qd*, based on a correspondence relationship between the derived second rotation value and the first rotation value Eu contained in the correspondence relationship information 86 in advance.

In the embodiment described above, the R-axis encoder 70, the first Q-axis encoder 73, and the second Q-axis encoder 76 are all absolute type encoders; however, the embodiment is not limited thereto. For example, one of the encoders may be an incremental encoder that generates a pulse having a frequency proportional to a rotation speed. For example, even in a case where the first Q-axis encoder 73 is the incremental encoder, it is possible to acquire the first rotation value by detecting a signal (Z-phase signal or the like) for detecting the origin of the rotation.

In the embodiment described above, the element section 75 of the first Q-axis encoder 73 can be opposite to the code section 74 at either of the lifted position or the lowered position of the suction nozzle 42; however, the embodiment is not limited thereto. For example, the first rotation values may be acquired by different encoders at the lifted position and the lowered position. In addition, the first Q-axis encoder 73 may acquire the first rotation value at the lifted position, and the mounting apparatus 11 may include an encoder that is capable of acquiring the first rotation value at the lowered position.

In the embodiment described above, the fiducial mark 59 is disposed on the syringe member 56 (flange 58) of the component holding section 55; however, the embodiment is not limited thereto, as long as the fiducial mark is disposed on the component holding section 55. For example, the fiducial mark 59 may be disposed on the flange 43 of the suction nozzle 42. In this case, when mounting or replacement with a new suction nozzle 42 is performed to the mounting head 50, the correspondence relationship acquiring process routine in Fig. 5 may be performed regarding the suction nozzle 42 (component holding section 55).

Industrial Applicability

The present invention can be used in a mounting apparatus that mounts a component on a board.

Reference Signs List

10: mounting system, 11: mounting apparatus, 14: board conveyance unit, 15: board supporting unit, 16: head moving unit, 17: mounting head unit, 18: supply unit, 19: parts camera, 20: nozzle stocker, 21: support plate, 22: conveyor belt, 23: support pin, 26: X-axis slider, 28: guide rail, 30: Y-axis slider, 32: guide rail, 40: head holder, 42: suction nozzle, 43: flange, 44: pipe-shaped section, 45: holder main body, 46: engagement shaft, 47: support member, 48: horizontal section, 50: mounting head, 51: rotary section, 52: R-axis gear, 53: Q-axis gear, 55: component holding section, 56: syringe member, 57: small gear, 58: flange, 59: fiducial mark, 60: R-axis motor, 61: encoder, 63: Q-axis motor, 64: encoder, 65: small gear, 66: Z-axis motor, 67: Z-axis guide, 68: horizontal section, 70: R-axis encoder, 71: code section, 72: element section, 73: first Q-axis encoder, 74: code section, 75: element section, 76: second Q-axis encoder, 77: code section, 78: element section, 80: control section, 81: CPU, 82: ROM, 83: HDD, 84: RAM, 85: input and output interface, 86, 86a: correspondence relationship information, 90: management computer, P: component, S: board

**Claims**

1.  A mounting apparatus (11) comprising:

    a mounting head unit (17) able to move in the two horizontal directions (X,Y);
    a component holding section (55) that is attached to the mounting head unit (17), is rotatable around a rotation axis and holds a component (P);
    a first acquisition section (73) that is configured to detect a rotational position of the component holding section (55) and acquires a first rotation value (Eu) indicating the rotational position;
    a second acquisition section (19, 80) that detects a specific part of the component holding section (55) and acquires a second rotation value (Qu) indicating the rotational position of the component holding section (55);
    a third acquisition section (19, 80) that is configured to detect a rotational position of a component (P) held by the component holding section (55) and acquires a component rotation value (Pu) indicating the rotational position;
    a correspondence relationship acquisition section (80) that is configured to acquire a correspondence relationship by using the first acquisition section (73) and the second acquisition section (19, 80);
    a target rotation value deriving section (80); and
    a rotation control section (80) that is configured to rotate the component holding section (55) such that the first rotation value (Eu) acquired by the first acquisition section (73) becomes the target rotation value (Eu*)

**characterized in that:**

the component holding section (55) is capable of being lifted and lowered,
wherein the correspondence relationship acquisition section (80) is configured to acquire, as a correspondence relationship, a correspondence relationship between the first rotation value (Eu) of the component holding section (55) at a lifted position and the second rotation value (Qd) of the component holding section (55) at a lowered position,
wherein the target rotation value deriving section (80) is configured to derive, as a target rotation value (Eu*), the first rotation value (Eu) of the component holding section (55) at the lifted position which corresponds to the second rotation value (Qd*) of the component holding section (55) at the lowered position, by which the component (P) has a target posture (Pd*) at the lowered position of the component holding section (55), based on the correspondence relationship and a difference (D) between the second rotation value (Qu) and the component rotation value (Pu) obtained in a state in which the component holding section (55) holds the component, and
wherein the rotation control section (80) is configured to rotate the component holding section (55) such that the first rotation value (Eu) acquired by the first acquisition section (73) at the lifted position of the component holding section (55) becomes the target rotation value (Eu*).

2. The mounting apparatus (11) according to claim 1,
wherein the second acquisition section (19, 80) is configured to serve as the third acquisition section (19, 80), has an imaging section that is capable of imaging the specific part and the component (P) held by the component holding section (55) simultaneously from a direction along the rotation axis, and acquires the second rotation value (Qu) and the component rotation value based on an image obtained by the imaging.

3. The mounting apparatus (11) according to claim 1 or 2,
wherein the correspondence relationship acquisition section (80) is configured to perform acquiring the first rotation values (Eu) and the second rotation values (Qu, Qd) multiple times by changing the rotational position of the component holding section (55) and is configured to acquire the correspondence relationship based on results of the acquiring.

4. The mounting apparatus (11) according to any one of claims 1 to 3, further comprising:

a plurality of component holding sections (55),
wherein the plurality of component holding sections (55) and the first acquisition section (73) are capable of performing relative movement with respect to each other, and the component holding section (55) that is opposite to the first acquisition section (73) can be switched through the relative movement,
wherein the first acquisition section (73) is configured to acquire the first rotation value of the opposite component holding section (55),
wherein the correspondence relationship acquisition section (80) is configured to acquire the correspondence relationship for each of the plurality of component holding sections (55),
wherein the target rotation value deriving section (80) is configured to derive the target rotation value for each of the plurality of component holding sections (55), and
wherein the rotation control section (80) is configured to rotate the component holding section (55) such that the first rotation value acquired for each of the plurality of component holding sections (55) by the first acquisition section (73) becomes the target rotation value.

5. The mounting apparatus (11) according to any one of claims 1 to 4,

wherein the component holding section (55) has a cylindrical section (74), and
wherein the first acquisition section (73) is disposed at a position opposite to an outer peripheral surface of the cylindrical portion of the component holding section (55) and is configured to acquire the first rotation value of the opposite component holding section (55).

**Patentansprüche**

1. Eine Montagevorrichtung (11) umfassend:

eine Montagekopfeinheit (17), die sich in den beiden horizontalen Richtungen (X, Y) bewegen kann;

einen Komponentenhalteabschnitt (55), der an der Montagekopfeinheit (17) angebracht ist, um eine Rotationsachse drehbar ist und eine Komponente (P) hält;

einen ersten Erfassungsabschnitt (73), der konfiguriert ist, um eine Drehposition des Komponentenhalteabschnitts (55) zu erkennen und einen ersten Drehwert (Eu) zu erfassen, der die Drehposition angibt;

einen zweiten Erfassungsabschnitt (19, 80), der einen bestimmten Teil des Komponentenhalteabschnitts (55) erkennt und einen zweiten Drehwert (Qu) erfasst, der die Drehposition des Komponentenhalteabschnitts (55) angibt;

einen dritten Erfassungsabschnitt (19, 80), der konfiguriert ist, um eine Drehposition einer Komponente (P) zu erkennen, die von dem Komponentenhalteabschnitt (55) gehalten wird, und einen Komponentendrehwert (Pu) erfasst, der die Drehposition anzeigt;

einen Korrespondenzbeziehungserfassungsabschnitt (80), der konfiguriert ist, um eine Korrespondenzbeziehung unter Verwendung des ersten Erfassungsabschnitts (73) und des zweiten Erfassungsabschnitts (19, 80) zu erfassen;

einen Zieldrehwert-Ableitungsabschnitt (80); und

einen Rotationssteuerabschnitt (80), der konfiguriert ist, um den Komponentenhalteabschnitt (55) so zu drehen, dass der erste Drehwert (Eu), der von dem ersten Erfassungsabschnitt (73) erfasst wird, der Zieldrehwert (Eu*) wird

**gekennzeichnet dadurch dass:**

der Komponentenhalteabschnitt (55) angehoben und abgesenkt werden kann, wobei

der Korrespondenzbeziehungserfassungsabschnitt (80) konfiguriert ist, um als Korrespondenzbeziehung eine Korrespondenzbeziehung zwischen dem ersten Drehwert (Eu) des Komponentenhalteabschnitts (55) an einer angehobenen Position und dem zweiten Drehwert (Qd) des Komponentenhalteabschnitts (55) in einer abgesenkten Position, zu erfassen, wobei

der Korrespondenzbeziehungserfassungsabschnitt (80) so konfiguriert ist, als den Zieldrehwert (Eu*), den ersten Drehwert (Eu) des Komponentenhalteabschnitts (55) an der angehobenen Position abzuleiten, der dem zweiten Drehwert (Qd*) des Komponentenhalteabschnitts (55) an der abgesenkten Position entspricht, an dem die Komponente (P) eine Zielstellung (Pd*) an der abgesenkten Position des Komponentenhalteabschnitts (55) aufweist, basierend auf der Korrespondenzbeziehung und einer Differenz (D) zwischen dem zweiten Drehwert (Qu) und dem Komponentendrehwert (Pu), der in einem Zustand erhalten wird, in dem der Komponentenhalteabschnitt (55) die Komponente hält, und wobei

der Rotationssteuerabschnitt (80) konfiguriert ist, um den Komponentenhalteabschnitt (55) so zu drehen, dass der erste Drehwert (Eu), der von dem ersten Erfassungsabschnitt (73) an der angehobenen Position des Komponentenhalteabschnitts (55) erfasst wird, der Zieldrehwert (Eu*) wird.

2. Die Montagevorrichtung (11) gemäß Anspruch 1, wobei
der zweite Erfassungsabschnitt (19, 80) konfiguriert ist, um als dritter Erfassungsabschnitt (19, 80) zu dienen, einen Abbildungsabschnitt aufweist, der in der Lage ist, das spezifische Teil und die Komponente (P), die von dem Komponentenhalteabschnitt (55) gehalten wird, gleichzeitig aus einer Richtung entlang der Rotationsachse abzubilden, und den zweiten Drehwert (Qu) und den Komponentendrehwert basierend auf einem durch die Abbildung erhaltenen Bild zu erfassen.

3. Die Montagevorrichtung (11) gemäß Anspruch 1 oder 2, wobei
der Korrespondenzbeziehungserfassungsabschnitt (80) konfiguriert ist, das Erfassen der ersten Drehwerte (Eu) und der zweiten Drehwerte (Qu, Qd) durch mehrmaliges Ändern der Rotationsposition des Komponentenhalteabschnitts (55) durchzuführen, und konfiguriert ist, die Korrespondenzbeziehung basierend auf den Ergebnissen des Erfassung zu erfassen.

4. Die Montagevorrichtung (11) gemäß einem der Ansprüche 1 bis 3, des weiteren umfassend:

eine Vielzahl von Komponentenhalteabschnitten (55), worin
die Vielzahl von Komponentenhalteabschnitten (55) und der erste Erfassungsabschnitt (73) eine Relativbewegung zueinander ausführen können, und der Komponentenhalteabschnitt (55), der dem ersten Erfassungsabschnitt (73) gegenüberliegt, durch die Relativbewegung geschaltet werden kann, wobei
der erste Erfassungsabschnitt (73) konfiguriert ist, um den ersten Drehwert des gegenüberliegenden Komponentenhalteabschnitts (55) zu erfassen, wobei
der Korrespondenzbeziehungserfassungsabschnitt (80) konfiguriert ist, um die Korrespondenzbeziehung für jeden der Vielzahl von Komponentenhalteabschnitten (55) zu erfassen, wobei der Korrespondenzbeziehungserfassungsabschnitt (80) konfiguriert ist, um den Zieldrehwert für jeden der Vielzahl von Komponentenhalteabschnitten (55) abzuleiten, und wobei der Rotationssteuerabschnitt (80) konfiguriert ist, den Komponentenhalteabschnitt (55) so zu drehen, dass der erste Drehwert, der für jeden der Vielzahl von Komponentenhalterungsabschnitten (55) durch den ersten Erfassungsabschnitt (73) erfasst wird, der Zieldrehwert wird.

5. Die Montagevorrichtung (11) gemäß einem der Ansprüche 1 bis 3, wobei

der Komponentenhalteabschnitt (55) einen zylindrischen Abschnitt (74) hat und wobei der erste Erfassungsabschnitt (73) an einer Position gegenüber einer äußeren Umfangsfläche des zylindrischen Abschnitts des Komponentenhalteabschnitts (55) angeordnet ist und konfiguriert ist, um den ersten Drehwert des gegenüberliegenden Komponentenhalteabschnitts (55) zu erfassen.

## Revendications

1. Appareil de montage (11) comprenant :

une unité formant tête de montage (17) pouvant se déplacer dans les deux directions horizontales (X, Y),
une section de support de composant (55) qui est fixée à l'unité formant tête de montage (17), qui peut tourner autour d'un axe de rotation et qui soutient un composant (P),
une première section d'acquisition (73) qui est configurée pour détecter la position en rotation de la section de support de composant (55) et pour acquérir une première valeur de rotation (Eu) indiquant la position en rotation,
une deuxième section d'acquisition (19, 80) qui détecte une partie spécifique de la section de support de composant (55) et qui acquiert une seconde valeur de rotation (Qu) indiquant la position en rotation de la section de support de composant (55),
une troisième section d'acquisition (19, 80) qui est configurée pour détecter la position en rotation d'un composant (P) soutenu par la section de support de composant (55) et qui acquiert une valeur de rotation de composant (Pu) indiquant la position en rotation,
une section d'acquisition de relation de correspondance (80) qui est configurée pour acquérir une relation de correspondance en utilisant la première section d'acquisition (73) et la deuxième section d'acquisition (19, 80),
une section de déduction de valeur de rotation cible (80), et
une section de commande de rotation (80) qui est configurée pour faire tourner la section de support de composant (55) de sorte à ce que la première valeur de rotation (Eu) acquise par la première section d'acquisition (73) devienne la valeur de rotation cible (Eu*),

caractérisé en ce que :

la section de support de composant (55) peut être élevée et abaissée, la section d'acquisition de relation de correspondance (80) étant configurée pour acquérir en tant que relation de correspondance une relation de correspondance entre la première valeur de rotation (Eu) de la section de support de composant (55) à une position élevée et la seconde valeur de rotation (Qd) de la section de support de composant (55) à une position abaissée,
dans lequel la section de déduction de valeur de rotation cible (80) est configurée pour déduire, en tant que valeur de rotation cible (Eu*), la première valeur de rotation (Eu) de la section de support de composant (55) au niveau de la position élevée qui correspond à la seconde valeur de rotation (Qd*) de la section de support de composant (55) à la position abaissée, grâce à quoi le composant (P) présente une orientation cible (Pd*) à la position abaissée de la section de support de composant (55) sur la base de la relation de correspondance et de la différence (D) entre la seconde valeur de rotation (Qu) et la valeur de rotation de composant (Pu) lorsque la section de support de composant (55) soutient le composant, et
dans lequel la section de commande de rotation (80) est configurée pour faire tourner la section de support de composant (55) de sorte à ce que la première valeur de rotation (Eu), acquise par la première section d'acquisition (73) à la position élevée de la section de support de composant (55), devienne la valeur de rotation cible (Eu*).

2. Appareil de montage (11) selon la revendication 1,
dans lequel la deuxième section d'acquisition (19, 80) est configurée pour servir de troisième section d'acquisition (19, 80), en tant que section de mise en image qui peut mettre en image simultanément depuis une direction le long de l'axe de rotation la partie spécifique et le composant (P) soutenu par la section de support de composant (55), et pour acquérir la seconde valeur de rotation (Qu) et la valeur de rotation de composant sur la base d'une image obtenue par la mise en image.

3. Appareil de montage (11) selon la revendication 1 ou la revendication 2, dans lequel la section d'acquisition de relation de correspondance (80) est configurée pour effectuer de multiples fois l'acquisition de la première valeur de rotation (Eu) et des secondes valeurs de rotation (Qu, Qd) en changeant la position en rotation de la section de support de composant (55), et elle est configurée pour acquérir la relation de correspondance sur la base des résultats de l'acquisition.

4. Appareil de montage (11) selon l'une quelconque des revendications 1 à 3, comprenant en outre :

une pluralité de sections de support de composant (55), dans lequel la pluralité de sections de support de composant (55) et la première section d'acquisition (73) peuvent effectuer un mouvement relatif les unes par rapport aux autres, et où la section de support de composant (55) qui est opposée à la première section d'acquisition (73) peut être commutée au travers du mouvement relatif, dans lequel la première section d'acquisition (73) est configurée pour acquérir la première valeur de rotation de la section de support de composant (55) opposée, dans lequel la section d'acquisition de relation de correspondance (80) est configurée pour acquérir la relation de correspondance pour chacune de la pluralité de sections de support de composant (55), dans lequel la section de déduction de valeur de rotation cible (80) est configurée pour déduire la valeur de rotation cible pour chacune de la pluralité de sections de support de composant (55), et dans lequel la section de commande de rotation (80) est configurée pour faire tourner la section de support de composant (55) de sorte à ce que la première valeur de rotation acquise pour chacune de la pluralité de sections de support de composant (55) par la première section d'acquisition (73) devienne la valeur de rotation cible.

5. Appareil de montage (11) selon l'une quelconque des revendications 1 à 4, dans lequel la section de support de composant (55) présente une section cylindrique (74), et dans lequel la première section d'acquisition (73) est placée à une position opposée à la surface périphérique externe de la partie cylindrique de la section de support de composant (55), et elle est configurée pour acquérir la première valeur de rotation de la section de support de composant (55) opposée.

FIG. 1

FIG. 2

FIG. 3

(a)

(b)

FIG. 4

FIG. 5

```
        ┌─────────────────────────────┐
        │   CORRESPONDENCE            │
        │   RELATIONSHIP ACQUIRING    │
        │   PROCESS ROUTINE           │
        └─────────────────────────────┘
                     │
        ┌─────────────────────────────┐
        │   MOVE MOUNTING HEAD OVER    │──── S100
        │   PARTS CAMERA              │
        └─────────────────────────────┘
                     │
        ┌─────────────────────────────┐
        │   SET COMPONENT HOLDING     │──── S110
        │   SECTION OF ACQUISITION TARGET │
        └─────────────────────────────┘
                     │
        ┌─────────────────────────────┐
        │   POSITION R-AXIS SUCH THAT  │──── S120
        │   ACQUISITION TARGET IS OPPOSITE │
        │   TO FIRST Q-AXIS ENCODER    │
        └─────────────────────────────┘
                     │
        ┌─────────────────────────────┐
        │   SET ROTATIONAL POSITION    │──── S130
        │   (ANGLE) OF ACQUISITION TARGET │
        └─────────────────────────────┘
                     │
        ┌─────────────────────────────┐
        │   POSITION Q-AXIS SUCH THAT FIRST Q- │──── S140
        │   AXIS ENCODER VALUE (FIRST ROTATION │
        │   VALUE Eu) AT LIFTED POSITION │
        │   BECOMES ACQUISITION TARGET ANGLE │
        └─────────────────────────────┘
                     │
        ┌─────────────────────────────┐
        │   ACQUIRE AND STORE FIRST Q-AXIS │──── S150
        │   ENCODER VALUE (FIRST ROTATION │
        │   VALUE Eu) AND SECOND ROTATION │
        │   VALUE Qu BASED ON CAPTURED IMAGE │
        └─────────────────────────────┘
                     │
        ┌─────────────────────────────┐
        │   ACQUIRE AND STORE SECOND ROTATION │──── S160
        │   VALUE Qd BASED ON CAPTURED IMAGE │
        │   AT LOWERED POSITION        │
        └─────────────────────────────┘
                     │
   YES    ╱─────────────────────────────╲
   ◄──────   IS THERE ROTATIONAL POSITION   ──── S170
          ╲  OF WHICH VALUES ARE NOT       ╱
           ╲ ACQUIRED?                    ╱
                     │ NO
   YES    ╱─────────────────────────────╲
   ◄──────   IS THERE COMPONENT HOLDING    ──── S180
          ╲  SECTION OF WHICH VALUES ARE   ╱
           ╲ NOT ACQUIRED?                ╱
                     │ NO
        ┌─────────────────────────────┐
        │            END              │
        └─────────────────────────────┘
```

FIG. 6

FIG. 7

| | | Eu1<br>(0°) | Eu2<br>(45°) | Eu3<br>(90°) | Eu4<br>(135°) | Eu5<br>(180°) | Eu6<br>(225°) | Eu7<br>(270°) | Eu8<br>(315°) |
|---|---|---|---|---|---|---|---|---|---|
| LIFTED<br>STATE | FIRST ROTATION<br>VALUE Eu | Eu1<br>(0°) | Eu2<br>(45°) | Eu3<br>(90°) | Eu4<br>(135°) | Eu5<br>(180°) | Eu6<br>(225°) | Eu7<br>(270°) | Eu8<br>(315°) |
| | SECOND ROTATION<br>VALUE Qu | Qu1 | Qu2 | Qu3 | Qu4 | Qu5 | Qu6 | Qu7 | Qu8 |
| LOWERED<br>STATE | SECOND ROTATION<br>VALUE Qd | Qd1 | Qd2 | Qd3 | Qd4 | Qd5 | Qd6 | Qd7 | Qd8 |

24

FIG. 8

```
                    ┌──────────────────────────────┐
                    │ COMPONENT PICKING AND        │
                    │ DISPOSITION PROCESS ROUTINE  │
                    └──────────────────────────────┘
                                  │
        ┌─────────────────────────────────────────────┐
        │ PICK UP(SUCTION) COMPONENT OF               │ ── S200
        │ MOUNTING TARGET BY EACH NOZZLE              │
        └─────────────────────────────────────────────┘
                                  │
        ┌─────────────────────────────────────────────┐
        │ PERFORM IMAGING BY PARTS CAMERA             │ ── S210
        │ FROM BELOW                                  │
        └─────────────────────────────────────────────┘
                                  │
        ┌─────────────────────────────────────────────┐
        │ ACQUIRE SECOND ROTATION VALUE Qu AND        │ ── S220
        │ COMPONENT ROTATION VALUE Pu BASED           │
        │ ON CAPTURED IMAGE FOR EACH NOZZLE           │
        └─────────────────────────────────────────────┘
                                  │
        ┌─────────────────────────────────────────────┐
        │ SET SUCTION NOZZLE OF MOUNTING TARGET       │ ── S230
        └─────────────────────────────────────────────┘
                                  │
        ┌─────────────────────────────────────────────┐
        │ START MOVING OF MOUNTING HEAD TO            │ ── S240
        │ MOUNTING POSITION ON BOARD                  │
        └─────────────────────────────────────────────┘
                                  │
        ┌─────────────────────────────────────────────┐
        │ DERIVE TARGET ROTATION VALUE Eu* OF         │ ── S250
        │ FIRST ROTATION VALUE Eu FOR SUCTION         │
        │ NOZZLE OF MOUNTING TARGET                   │
        └─────────────────────────────────────────────┘
                                  │
        ┌─────────────────────────────────────────────┐
        │ POSITION R-AXIS SUCH THAT                   │ ── S260
        │ MOUNTING TARGET NOZZLE IS                   │
        │ OPPOSITE TO FIRST Q-AXIS ENCODER            │
        └─────────────────────────────────────────────┘
                                  │
        ┌─────────────────────────────────────────────┐
        │ POSITION Q-AXIS SUCH THAT FIRST             │ ── S270
        │ ROTATION VALUE Eu IN LIFTED STATE           │
        │ BECOMES TARGET ROTATION VALUE Eu*           │
        └─────────────────────────────────────────────┘
                                  │
          NO      ╱───────────────────────────╲
        ◄─────────   IS MOVING TO MOUNTING      ── S280
                  ╲     POSITION ENDED?        ╱
                    ╲───────────────────────╱
                              │ YES
        ┌─────────────────────────────────────────────┐
        │ LOWER NOZZLE AND MOUNT                      │ ── S290
        │ COMPONENT ON BOARD                          │
        └─────────────────────────────────────────────┘
                              │
          YES     ╱───────────────────────────╲
        ◄─────────  IS THERE COMPONENT THAT IS   ── S300
                  ╲  PICKED UP BUT UNMOUNTED?  ╱
                    ╲───────────────────────╱
                              │ NO
                    ┌──────────────────┐
                    │       RET        │
                    └──────────────────┘
```

25

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013143396 A
- US 2002031279 A1
- JP 2006108331 A
- JP 2004281468 A